(19) Europäisches Patentamt
European Patent Office
Office européen des brevets

(11) **EP 3 358 357 A1**

(12) **EUROPEAN PATENT APPLICATION**
published in accordance with Art. 153(4) EPC

(43) Date of publication:
**08.08.2018 Bulletin 2018/32**

(51) Int Cl.:
*G01P 15/08* (2006.01)     *B81B 3/00* (2006.01)
*G01C 19/5747* (2012.01)     *G01C 19/5783* (2012.01)
*G01D 21/02* (2006.01)     *G01L 9/00* (2006.01)
*G01P 15/125* (2006.01)     *G01P 15/18* (2013.01)
*H01L 29/84* (2006.01)

(21) Application number: **16850874.5**

(22) Date of filing: **03.08.2016**

(86) International application number:
**PCT/JP2016/072713**

(87) International publication number:
**WO 2017/056697 (06.04.2017 Gazette 2017/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **30.09.2015 JP 2015192519**

(71) Applicant: **Hitachi Automotive Systems, Ltd.
Hitachinaka-shi, Ibaraki 312-8503 (JP)**

(72) Inventors:
• **DEGAWA, Munenori**
 **Hitachinaka-shi**
 **Ibaraki 312-8503 (JP)**
• **KIKUCHI, Hiroshi**
 **Hitachinaka-shi**
 **Ibaraki 312-8503 (JP)**

(74) Representative: **Strehl Schübel-Hopf & Partner**
 **Maximilianstrasse 54**
 **80538 München (DE)**

(54) **INERTIA SENSOR**

(57)     Provided is an inertia sensor that can be reduced in size. An inertia sensor having layers 1a, 2a in which detection parts 20, 30 are formed, the inertial sensor being a laminated structure obtained by laminating two or more of the layers.

*FIG. 1*

**Description**

Technical Field

The present invention relates to an inertial force sensor, and more particularly to an acceleration sensor and an angular velocity sensor for measuring a motion state of a moving object such as a vehicle, an airplane, a robot, a mobile phone, a video camera.

Background Art

In recent years, inertial force sensors using microelectromechanical systems (MEMS) devices are being widely used for the purpose of preventing camera shake of a digital camera, attitude control of automobiles, robots, or the like.
Generally, this type of inertial force sensor is formed by processing a semiconductor substrate such as silicon, a glass substrate, or the like, using an MEMS fabrication process such as etching, in which air-tightly sealed voids are formed by bonding the substrate with another substrate under constant atmosphere and pressure environment. For example, PTL 1 describes an inertial force sensor including an acceleration detector and an angular velocity detector.
The acceleration detector includes a movable mechanical component that is a movable body formed with weights, beams, or the like. When the acceleration is applied, the movable body is displaced. Acceleration is detected by detecting a displacement amount of the movable body. In contrast, the angular velocity detector includes a movable mechanical component that is a vibrating body and applying angular velocity to a state in which the vibrating body drives at a certain frequency generates a Coriolis force. This Coriolis force causes the vibrating body to be displaced. The angular velocity is detected by detecting a displacement amount of the vibrating body by this Coriolis force.

Citation List

Patent Literature

PTL 1: JP 5298047 B2

Summary of Invention

Technical Problem

Meanwhile, in the above-described conventional technique, the acceleration detector and the angular velocity detector are installed on a same substrate. The acceleration detector and the angular velocity detector have mutually different performance requirements such as the detection sensitivity and the frequency response, and thus, the natural frequency, the electrode dimensions, or the like, for determining the structure of the detector are also different from each other. For example,' a natural frequency f is expressed by a relationship between a mass m of a weight and a spring constant k of a beam as expressed in Formula (1)
[Mathematical Formula 1]

$$f = \frac{1}{2\pi} \sqrt{\frac{k}{m}} \quad \cdots (1)$$

Herein, the mass m of the weight is expressed by Formula (2), while the spring constant k is expressed by Formula (3)
[Mathematical Formula 2]

$$m = Sh\rho \quad \dots (2)$$

In Formula (2), S, h, and $\rho$ are the following numerical values.

S: area (area of the weight as viewed from the substrate surface)

h: substrate thickness (thickness of the weight as viewed from the substrate front surface)

ρ: density (density of a material constituting the substrate)

[Mathematical Formula 3]

$$k = \alpha \frac{Ehw^3}{l^3} \quad \cdots (3)$$

In Formula (3), α, w, l, and E are the following numerical values.

α: a constant

w: beam width (width of the beam viewed from the substrate front surface)

l: length of beam

E: Young's modulus

From Formulas (1), (2) and (3), the natural frequency f is expressed by Formula (4).

[Mathematical Formula 4]

$$f = \frac{\alpha}{2\pi} \sqrt{\frac{Ehw^3}{l^3 Sh\rho}} \quad \cdots (4)$$

In the, composite sensor, however, a natural frequency f1 of the acceleration detector is about 1 kHz to 3 kHz, while a natural frequency f2 of the angular velocity detector is about 15 kHz to 25 kHz, leading to a difference between them in some cases.

For example, when the angular velocity detector and the acceleration detector are formed on a same substrate, a thickness h of the substrate is common to the two detectors. Moreover, from a viewpoint of the MEMS fabrication process described above, variation in fabricated shapes can be more equalized by also using a common beam width w. Accordingly, in order to obtain the mutually different natural frequencies f1 and f2, the area S and the length 1 of the beam are to be individually changed.

In the angular velocity detector, however, a Coriolis force Fc generated at application of the angular velocity has relationships illustrated in Formulas (5) and (6) with respect to an angular velocity $\Omega$. Therefore, in order to increase the Coriolis force, it is preferable to increase the mass of the weight m22, and thus, it is difficult to reduce the mass of the weight $m_2$ in order to make the natural frequency f2 higher than the natural frequency f1.

[Mathematical Formula 5]

$$m_2 = m_{21} + m_{22} \quad \cdots (5)$$

In Formula (5), $m_{21}$ and $m_{22}$ are the following numerical values.

$m_{21}$: mass of a movable portion non-reacting to the angular velocity $\Omega$ in the weight m2

$m_{22}$: mass of the movable portion reacting to the angular velocity $\Omega$ in the weight m2

[Mathematical Formula 6]

$$Fc = -2m_{22}\Omega v \quad \cdots (6)$$

In Formula (6), v is the following numerical value.

v: velocity at drive of weight $m_2$

Solution to Problem

In order to solve the above-described problem, it is effective to configure such that an inertial force sensor according to the present invention includes a layer in which a detector is formed and that the layer has a laminated structure in which two or more layers are laminated. With this configuration, the thickness h can be set to an arbitrary thickness in each of the detectors.

Advantageous Effects of Invention

In order to achieve the above-described object, effects obtained by representative ones of the inventions disclosed in the present application will be briefly described as follows.

According to claim 1 of the present invention, an inertial force sensor includes a layer in which a detector is formed, and the layer is a laminated structure in which two or more layers are laminated. According to the present invention, since the detectors are formed in lamination, it is possible to achieve downsizing compared with a sensor in which detectors are arranged on a plane.

According to claim 4 of the invention, the inertial force sensor is characterized in that at least one pair of detectors is arranged such that the movable body and the electrode are formed in mutually different layers. According to the present invention, in a case where the movable body moves in a direction perpendicular to a plane and this movement is to be detected, the electrode is installed at a position facing the plane of the movable body, that is, in another layer. In this case, as described in claim 5 of the invention, the detector in which the movable body and the electrode are formed in mutually different layers is configured such that the electrode is formed in a same layer in which the movable body of another detector is formed. This makes it possible to reduce the height of the sensor chip because there is no need to provide another layer for the electrode.

According to claim 6 of the invention, the inertial force sensor is characterized to include two sets of the at least one pair of detectors being arranged in an array. According to the present invention, for example, by arranging, in the array, the individual detectors in a direction orthogonal to each other on a plane, it is possible to detect an inertial force in the two-dimensional direction. On the other hand, for example, by arranging the individual detectors in a same direction on the plane in the array, it is possible to detect a positional deviation between the individual detectors, detect warping and bending occurring in the sensor chip forming the array, and by correcting the warping and bending by an external circuit, it is possible to enhance detection accuracy of the sensor.

Brief Description of Drawings

FIG. 1 is an overall view of a sensor chip 10 according to a first embodiment of the present invention.
FIG. 2 is a cross-sectional view taken along line I-I in FIG. 1.
FIG. 3 is a plan view illustrating a II-II cross section of FIG. 2.
FIG. 4 is a plan view illustrating a III-III cross section of FIG. 2.
FIG. 5 is a modification of FIG. 3.
FIG. 6 is a principle diagram of acceleration signal detection.
Fig. 7 is a principle diagram of angular velocity signal detection
FIG. 8 is modification of FIG. 4.
FIG. 9 is a cross-sectional view of a chip package 4 according to the first embodiment of the present invention.
FIG. 10 is a modification of FIG. 9.
FIG. 11 is a cross-sectional view of a sensor chip 10a according to a second embodiment of the present invention.
FIG. 12 is a plan view illustrating a IV-IV cross section of FIG. 11.
FIG. 13 is a plan view illustrating a V-V cross section of FIG. 11.
FIG. 14 is a modification of FIG. 11.
FIG. 15 is a cross-sectional view of a sensor chip 10b according to a third embodiment of the present invention.
FIG. 16 is a plan view illustrating a VI-VI cross section of FIG. 15.
FIG. 17 is a plan view illustrating a VII-VII cross section of FIG. 15.
FIG. 18 is a modification of FIG. 15.
FIG. 19 is an overall view of a sensor chip 10c according to a fourth embodiment of the present invention.
FIG. 20 is a cross sectional view take along line VIII-VIII in FIG. 19.

Description of Embodiments

The following embodiments will be described by being divided into a plurality of sections or embodiments as needed for the sake of convenience. However, unless otherwise stated, the plurality of sections or embodiments is not irrelevant to each other, but rather in a relationship of one being a modification, elaboration, supplementary explanation, or the like, of a portion or all of another one.

In addition, when the number or the like of the components (including a number, a numerical value, an amount, a range) is referred to in the following embodiments, the number is not limited to a particular number but rather may be a number equal to or more/less than the particular number, except for the cases where explicitly stated, apparently limited to the particular number in principle, or the like.

Furthermore, components (including element steps, or the like) in the following embodiment are not necessarily indispensable, except for the cases where explicitly stated, considered apparently indispensable in principle, or the like.

In a similar manner, when a shape, a positional relationship, or the like, of the components, or the like, is referred to in the following embodiment, it is assumed that the shape, or the like, includes a shape substantially approximate or similar thereto, except for the cases where clearly explicitly state, apparently not conceivable in principle, or the like. This also applies to the above-described numerical values and ranges in a similar manner.

In all the drawings for illustrating the embodiments, identical members are denoted by same reference symbols in principle, and duplicated description thereof will be omitted. Even in a plan view, hatching are added to make the drawing more understandable.

(First Embodiment)

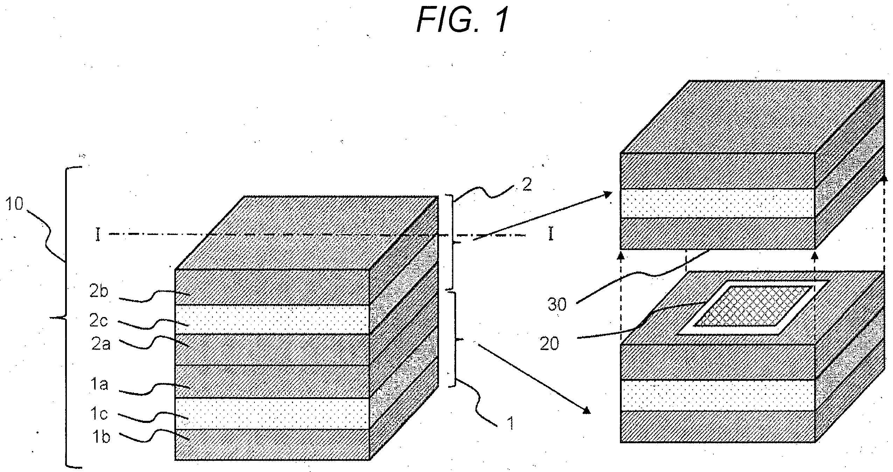

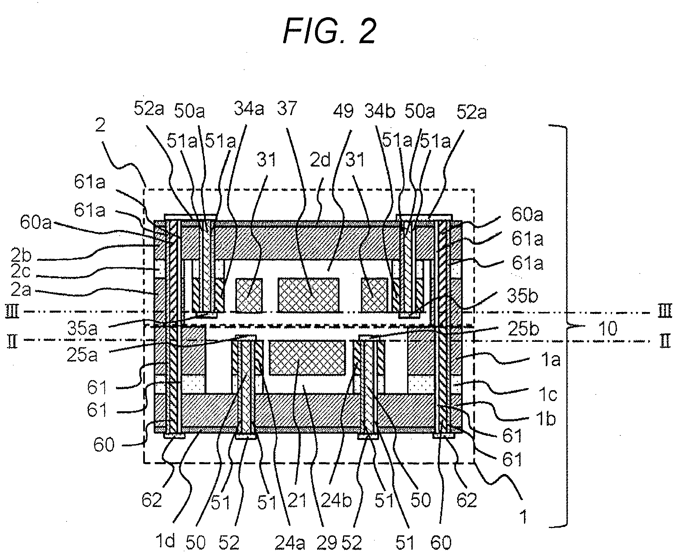

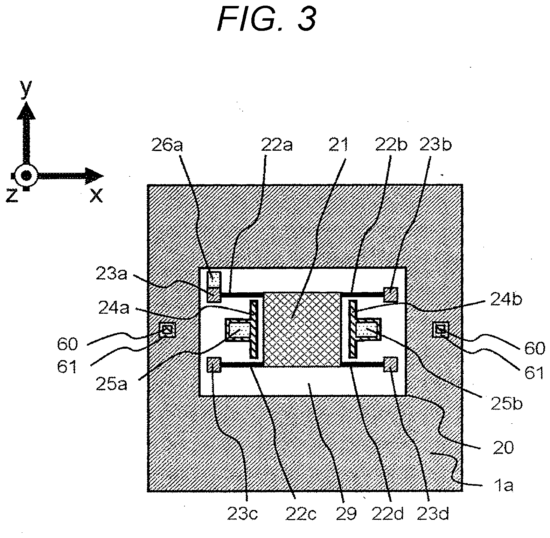

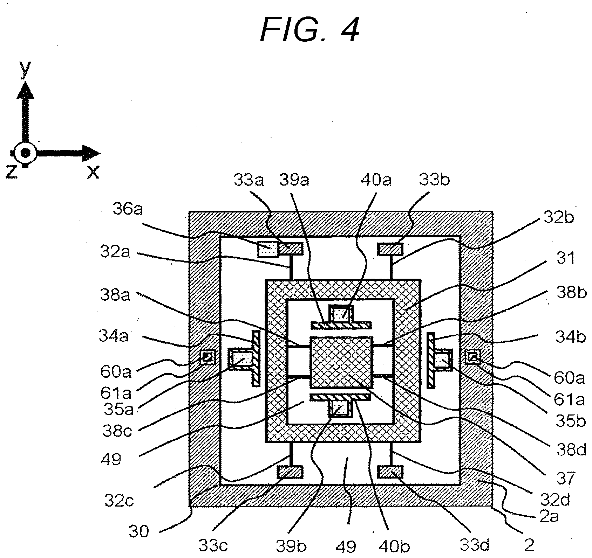

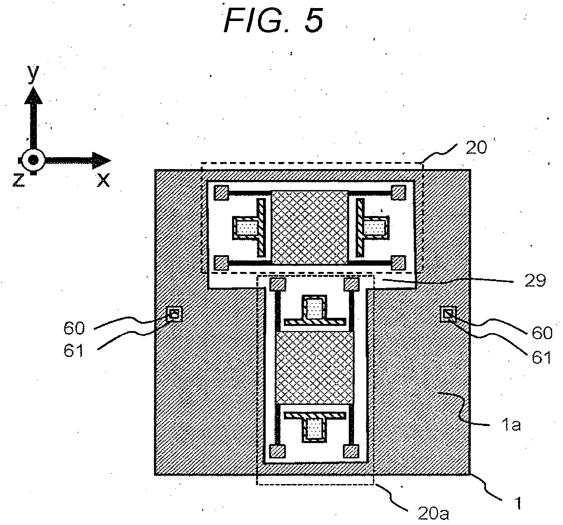

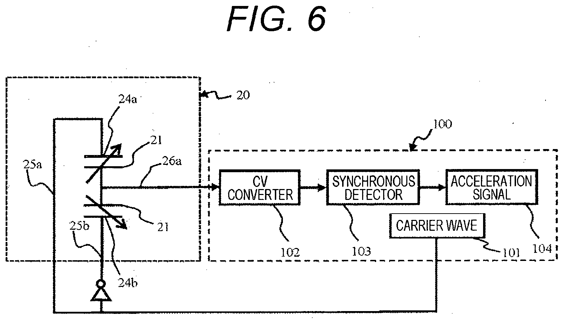

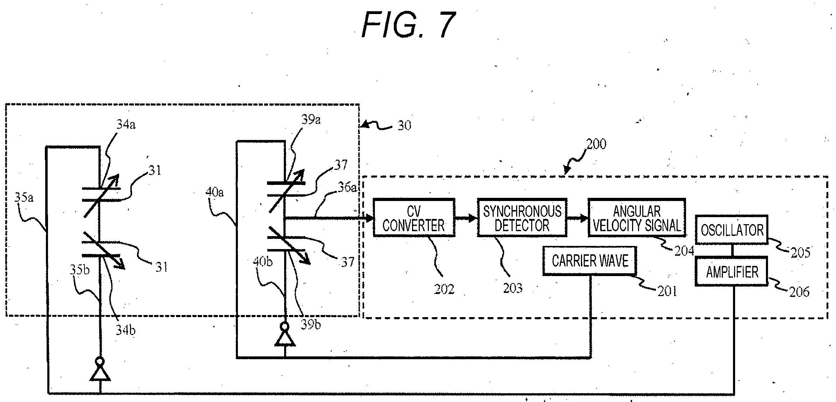

In the present embodiment, the invention will be described using a sensor chip for detecting acceleration and angular velocity. FIG. 1 is an overall view of a sensor chip 10 according to a first embodiment of the present invention. FIG. 2 is a cross sectional view taken along line I-I in FIG. 1. FIG. 3 is a plan view illustrating a II-II cross section of FIG. 2. FIG. 4 is a plan view illustrating a III-III cross section of FIG. 2. FIG. 5 illustrates a modification of FIG. 2. FIG. 6 is a principle diagram of acceleration signal detection. FIG. 7 is a principle diagram of an angular velocity detection signal.

In the present embodiment, the sensor chip 10 is constituted with an acceleration detector 20 configured to detect acceleration in the y-axis direction and a detector 30 configured to detect an angular velocity about the z-axis. In the sensor chip 10, the acceleration detector 20 is formed in a first laminate 1, and the angular velocity detector 30 is formed in a second laminate 2. The first laminate 1 and the second laminate 2 are laminated as illustrated in FIG. 2, and a signal of the acceleration detector 20 and a signal of the angular velocity detector 30 are extracted on a same side in order to facilitate connection to an external circuit to be described below.

First, the first laminate 1 and the acceleration detector 20 will be described.

The first laminate 1 has a configuration including a first substrate 1a consisting of mono-crystalline silicon, a second substrate 1b consisting of mono-crystalline silicon in a similar manner, and an oxide film 1c, in which the first substrate 1a and the second substrate 1b are laminated so as to sandwich the oxide film 1c therebetween. Alternatively, the laminate 1 may also use a substrate obtained by first forming an insulating film serving as the oxide film 1c on a substrate of silicon and glass bonded with each other, or on a silicon substrate serving as the second substrate 1b, and then forming on an upper portion thereof a conductive film such as a polysilicon film serving as the first substrate 1a.

Then, the laminate 1 is processed by photolithography and deep reactive ion etching (DRIE), thereby forming the acceleration detector 20.

As illustrated in FIG. 3, the acceleration detector 20 is formed on the first substrate 1a. The acceleration detector 20 includes a weight 21, fixed portions 23a, 23b, 23c, and 23d supported and fixed to the second substrate 1b via the oxide film 1c, and beams 22a, 22b, 22c, and 22d joined to the fixed portions and movably supporting the weight 21 in a movable (Y) direction (described below). At this time, the weight 21 is suspended from the beam and a portion around the weight 21 is in a hollow state surrounded by cavity 29 in order to enable the weight 21 to be movable.

For detecting the movable weight 21 and detecting a displacement amount of the weight 21 by application of acceleration as a change in capacitance, there provided are electrodes 24a and 24b for forming capacitance with the weight 21, and electrodes 25a, 25b, and 26a for exchanging signals with an external circuit. The electrodes 25a, 25b, and 26a are configured such that the electrode 25a corresponds to the electrode 24a, the electrode 25b to the electrode 24b, and the electrode 26a to the weight 21.

In order to connect the electrodes 25a, 25b, and 26a to the external circuit, there is a need to extract these electrodes to the outside of the laminate. Accordingly, as illustrated in FIG. 2, a penetrating electrode 50 is formed so as to penetrate the second substrate 1b, the oxide film 1c, and an insulating film 1d that insulates the electrode 52 described below. The penetrating electrode 50 is connected to the electrode 52.

In the penetrating electrode 50, the outer periphery of the penetrating electrode 50 is covered with an insulating film 51 in order to electrically insulate from the substrate through which the penetrating electrode 50 penetrates. On the other hand, the inside of the penetrating electrode 50 is formed by embedding a conductive material such as polysilicon or metal.

Furthermore, in order to connect the electrodes constituting the angular velocity detector 30 described below on the same side as the external circuit, there provided is a penetrating electrode 60 penetrating the first substrate 1a, the second substrate 1b, the oxide film 1c, and the insulating film 1d, and connection to the electrode 62 is performed via the penetrating electrode 60. Similarly to the penetrating electrode 50, the outer periphery of the penetrating electrode 60 is covered with an insulating film 61, and the inside is formed of a conductive material such as polysilicon or metal.

Subsequently, operation of the acceleration detector'20 according to the first embodiment will be described. In the first embodiment, the mass of the weight 21 is defined, as m1 and the sum of spring constants of the beams 22a, 22b, 22c, and 22d in the movable (y) direction is defined as $k_1$, as mainly illustrated in FIG. 3. At this time, when a force $F_1$ is generated in the weight 21 in a case where acceleration $a_1$ is applied in the movable (y) direction of the weight 21, the weight 21 is displaced in the movable (y) direction, leading to generation of a displacement amount $y_1$. This relationship is expressed by Formula (7).

[Mathematical Formula 7]

$$F_1 \ = \ m_1 a_1 \ = \ k_1 y_1 \ \dots \ (7)$$

When the displacement $y_1$ is generated, a distance between the weight 21 and each of the electrodes 24a and 24b varies, leading to a change in the capacitance of the weight 21 and the electrode 24a on the left side in a decreasing direction and leading to a change in the capacitance of the weight 21 and the electrode 24b on the right side in an increasing direction. For example, in a case where the weight 21 is displaced in the right direction in FIG. 3, the distance between the weight 21 and the electrode 24a on the left side increases, leading to a decrease in the capacitance, and at this time, the distance between the weight 21 and the electrode 24b on the right side decreases, leading to an increase in the capacitance.

This change in the capacitance is output to and processed in the external integrated circuit 100.

Specifically, as illustrated in FIG. 6, a carrier wave 101 for detecting the capacitance from the integrated circuit 100 formed on a semiconductor chip 3 is applied to the electrode 25a connected to the electrode 24a or to the electrode 25b connected to the electrode 24b, illustrated in FIG. 3. This causes a capacitance change signal to be output from .the electrode 26a connected to the fixed portion 23a joined to the weight 21 illustrated in FIG. 3 via the beam 22a. That is, a signal of capacitance change from the acceleration detector 20 is input to a CV converter 102. At this time, as illustrated in FIG. 6, the carrier wave 101 may be applied so as to have opposite phased waveforms between the electrode 25a and the electrode 25b. In this case, the signal of the capacitance change from the acceleration detector 20 can be input to the CV converter 102 by differential input. This makes it possible to increase the acceleration detection sensitivity.

In the CV converter 102, the capacitance change is converted into a voltage signal, and thereafter, the voltage signal is output to a synchronous detector 103. The synchronous detector 103 extracts solely a necessary signal component, and finally outputs an acceleration signal 104 in the form of voltage. At this time, the displacement amount $y_1$ of the weight 24 is proportional to the applied acceleration when the mass $m_1$ of the movable body and the total $k_1$ of the spring constants of the beams 22a, 22b, 22c, and 22d are constant. Accordingly, the applied acceleration can be detected by monitoring an output voltage (acceleration signal) proportional to the displacement amount $y_1$. The acceleration sensor according to the first embodiment operates as described above.

The above is an explanation of the acceleration detector 20 formed in the first laminate 1 according to the present embodiment. In this, for example, the acceleration in the x-axis direction is detected by arranging the acceleration detector 20 to be rotated by 90 degrees about the z-axis.

Furthermore, as illustrated in FIG. 5, by forming, in the first laminate 1, an acceleration detector 20a adjacent to the acceleration detector 20 and rotated by 90 degrees about the z-axis with respect to the acceleration detector 20, it is possible to detect acceleration of two axes in the x-axis direction and the y-axis direction in the first laminate 1.

Next, the second laminate 2 and the angular velocity detector 30 will be described.

The angular velocity detector 30 according to the present embodiment is formed by the second laminate 2, similarly to the first laminate 1.

As illustrated in FIG. 4, the angular velocity detector 30 is formed on a first substrate 2a constituting the second laminate 2. The angular velocity detector 30 includes: fixed portions 33a, 33b, 33c, and 33d supported and fixed to a second substrate 2b via an oxide film 2c; first beams 32a, 32b, 32c, and 32d respectively joined to the fixed portions and each movably supporting a first weight 31 described below; the first weight 31 suspended from the beams and movable in the movable (X) direction; and electrodes 34a and 34b configured to form capacitances with the weight 31 in order to drive the first weight 31.

The angular velocity detector 30 further includes second beams 38a, 38b, 38c and 38d configured to join a second weight 37 to the first weight 31 and movably supporting the second weight 37 in a direction (Y) orthogonal to the first weight 31; the second weight 37 movable in the orthogonal (y) direction with respect to the first weight 31 by application of angular velocity; and electrodes 39a and 39b that form capacitance with the second weight 37 in order to detect a displacement amount of the second weight 37 at application of angular velocity as a change in capacitance.

Moreover, as electrodes for exchanging signals with an external circuit, the angular velocity detector 30 further includes an electrode 35a for the electrode 34a, an electrode 35b for the electrode 34b, an electrode 36a for the second weight 37, an electrode 40a for the electrode 39a, and 40b for the electrode 39b.

In order to connect the electrodes 35a, 35b, 36a, 40a, and 40b to the external circuit, there is a need to extract these electrodes to the outside of the laminate 2. Here, first, similarly to the acceleration detector 20, a penetrating electrode 50a that penetrates the second substrate 2b, the oxide film 2c, and an insulating film 2d for insulating the electrode 52a described below is formed, and the penetrating electrode 50a is connected to the electrode 52a. Similarly to the penetrating electrode 50, the outer periphery of the penetrating electrode 50a is covered with the insulating film 51a, and the inside is formed of a conductive material such as polysilicon or metal.

Furthermore, in order to extract the electrode 52a to the same side as the electrode 52 formed in the first laminate 1, the electrode 52a is extended in a planar direction, and similarly to the penetrating electrode 60 formed in the acceleration detector 20, a penetrating electrode 60a penetrating the first substrate 2a, the second substrate 2b, the oxide film 2c, and the insulating film 2d is formed and connected to the electrode 52a. At this time, by arranging the penetrating electrode 60a at a position to be electrically connected to the penetrating electrode 60, the signal of the electrode 52a is connected to the electrode 62 arranged on the same side as the electrode 52. Similarly to the penetrating electrode 60, the outer periphery of the penetrating electrode 60a is covered with an insulating film 61a, and the inside is formed of a conductive material such as polysilicon or metal.

Subsequently, operation of the angular velocity detector 30 according to the first embodiment will be described.

First, in order to bring the first weight 31 into a state of vibrating with a constant frequency f and a constant amplitude Xe in the x-axis direction, an AC voltage of the frequency f is applied to the first electrodes 34a and 34b, so as to generate electrostatic force between the first weight 31 and the first electrodes 34a and 34b, thereby causing the first weight 31 to vibrate in the x-axis direction. The AC voltage is generated by an oscillator 205 provided, in an external integrated circuit 200. In the oscillator 205, an amplifier 206 may be interposed, in order to obtain a predetermined voltage.

In a state where the first weight 31 vibrates in the x-axis direction, the weight 37 as the second vibrating body vibrates in conjunction with the first weight 31 in the x-axis direction. At this time, the relationship between a displacement x in the x-axis direction of the first weight 31 and a velocity v thereof is expressed by Formula (8).
[Mathematical Formula 8]

$$x = \mathrm{XeSin}\ (2\pi ft)\ \ldots\ (8)$$

$$v = 2\pi f\mathrm{XeCos}\ (2\pi ft)\ \ldots\ (8)$$

In Formula (8), f, Xe, and t are the following numerical values.

f: frequency
Xe: amplitude
t: time

In a case where the angular velocity $\Omega$ is applied about the z-axis orthogonal to the paper surface of FIG. 4 in a state where the first weight 31 and the second weight 37 vibrate in the x-axis direction as described above, and when the mass of the second weight 37 is $m_{22}$, the Coriolis force Fc is generated in the y-axis direction as expressed by the above-described Formula (6). Then, the second weight 37 is displaced by the Coriolis force Fc in the y-axis direction.

The second weight 37 vibrates in the y-axis direction by the Coriolis force Fc expressed by Formula (6), and the capacitance between the second weight 37 and the second electrodes 39a and 39b changes. By detecting this capacitance change, it is possible to detect the angular velocity $\Omega$ about the z-axis.

This change in the capacitance is output to and processed in the external integrated circuit 200.

Specifically, as illustrated in FIG. 7, a carrier wave 201 for detecting the capacitance from the integrated circuit 200 formed on a semiconductor chip 3a is applied to the electrode 40a connected to the electrode 39a or to the electrode 40b connected to the electrode 39b, illustrated in FIG. 4.

This causes the signal of the second weight 37 illustrated in FIG. 7 to be connected to the first weight 31 via the second beams 38a, 38b, 38c, and 38d, and then, a capacitance change signal is output from the electrode 36a connected to the fixed portion 33a via the first beam 32a. That is, the capacitance change signal from the electrode 36a is input to a CV converter 202 of the integrated circuit 200.

At this time, as illustrated in FIG. 7, the carrier wave 201 may be applied so as to have opposite phased waveforms between the electrode 40a and the electrode 40b. In this case, the signal of the capacitance change from the angular velocity detector 30 can be input to the CV converter 202 by differential input. This makes it possible to increase angular velocity detection sensitivity.

In the CV converter 202, the capacitance change is converted into a voltage signal, and thereafter, the voltage signal is output to a synchronous detector 203. The synchronous detector 203 extracts solely a necessary signal component and finally outputs an angular velocity signal 204 in the form of voltage.

As a method of measuring the displacement amount of the weight 37 that is the second vibrating body, the voltage applied to the electrodes 39a and 39b may be servo-controlled such that the capacitance change between the weight 37 and the electrodes 39a, 39b, that is, the displacement amount in the y-axis direction of the weight 37 becomes zero, and the Coriolis force Fc may be obtained from the applied voltage.

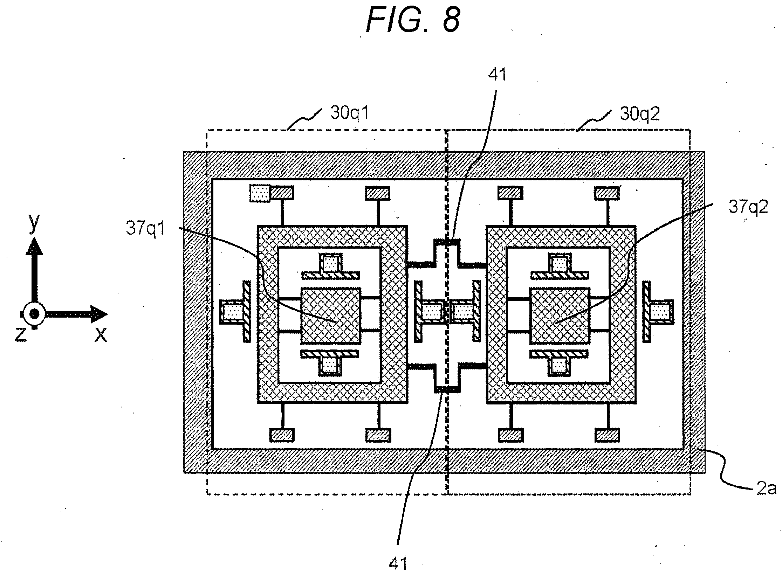

Moreover, as a modification of FIG. 4, as illustrated in FIG. 8, it is possible to provide a structure in which two angular velocity detectors 30 are arranged side by side, and an angular velocity detector 30q1 on the left side and an angular velocity detector 30q2 on the right side are provided with being mutually connected via a third beam 41 formed on the first substrate 2a. Then, by oscillating the first weight 31q1 on the left side and the first weight 31q2 on the right side in opposite phases, acceleration from the outside can be canceled out or counter balanced, and while doing this, the detection signal of the angular velocity can be detected with high sensitivity by obtaining a sum of a second weight 37q1 of the left side and a second weight 37q2 on the right side, leading to an advantage of capability of suppressing the vibration of a transducer from leaking to the outside.

The above is the description of the angular velocity detector 30 formed in the second laminate 2 according to the present embodiment. Alternatively, however, it is allowable to form an acceleration detector 20b in the second laminate 2, similarly to the acceleration detector 20.

At this time, the acceleration detector 20b may be arranged to be rotated by 90 degrees about the z-axis with respect to the acceleration detector 20, whereby the acceleration detector 20 detects the acceleration in the y-axis direction, while the acceleration detector 20b detects the acceleration about the x-axis, enabling the sensor chip 10 to be a biaxial acceleration sensor that detects acceleration in the x-axis and the y-axis directions.

In addition, the acceleration detector 20b is arranged in the same direction as the acceleration detector 20, while by changing the dimensions of the beam and the weight, and the thickness of the first substrate 2a so as to change the spring constant $k_1$ and the mass $m_1$ expressed in Formula (7) to different values, it is possible to change the acceleration detection range. As a result,' the sensor chip 10 can be a uniaxial acceleration sensor with a wider detection range without deteriorating detection accuracy.

Furthermore, the first laminate 1 according to the present embodiment may include an angular velocity detector 30a similarly to the angular velocity detector 30. At this time, by changing the dimensions of the beam and the weight, and the thickness of the first substrate 1a, so as to change the frequency f and the mass $m_2$ of the weight expressed in Formulas (8) and (9) to different values, it is possible to change the detection range of the angular velocity, enabling the sensor chip 10 to be a uniaxial angular velocity sensor with a wider detection range without deteriorating detection accuracy.

Moreover, by forming the integrated circuit 100 and the integrated circuit 200 on the same semiconductor chip 3, it is possible to downsize the semiconductor chip.

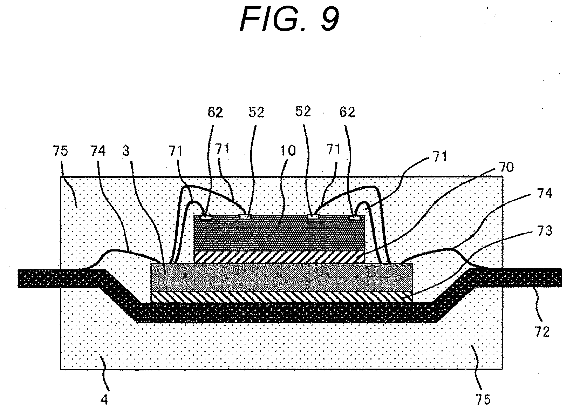

The sensor chip 10 constituted as described above is assembled in a chip package 4 as illustrated in FIG. 9. The sensor chip 10 is mounted on the semiconductor chip 3 via an adhesive 70 with an insulating film 2d side surface of the second laminate 2 facing the semiconductor chip 3, while the electrodes 52 and 62 of the sensor chip 10 are electrically connected to the semiconductor chip 3 via first wire bonding 71. The semiconductor chip 3 is mounted on a lead frame 72 via an adhesive 73, and the semiconductor chip 3 and the lead frame 72 are electrically connected via the second wire bonding 74. Then, these are sealed with resin 75, thereby forming the chip package 4.

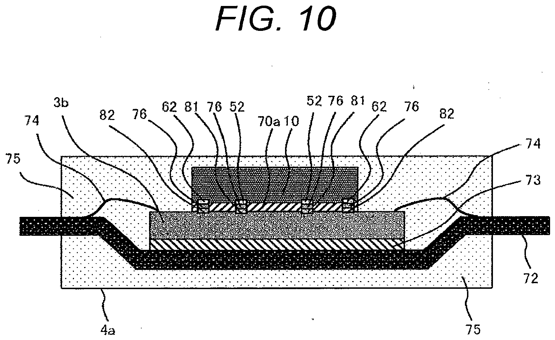

Furthermore, FIG. 10 illustrates as a chip package 4a as a modification of the chip package 4 illustrated in FIG. 9. In FIG. 10, a semiconductor chip 3b includes electrodes 81 and 82 connected to the electrodes 52 and 62 on the sensor chip 10 at positions facing the electrodes 52 and 62, respectively. Portions between the electrodes 52 and 81 and between the electrodes 62 and 82 are electrically connected via a conductive material 76 such as a solder bump, thereby bonding the sensor chip 10 and the semiconductor chip 3b to each other. At this time, an adhesive 73a may be present in a portion where the conductive material 76 is absent in order to obtain adhesion reliability between the sensor chip 10 and the semiconductor chip 3b. With the structure illustrated in FIG. 10, the first wire bonding 71 can be omitted, and the height of the chip package 4a can be reduced. In addition, the wiring between the sensor chip 10 and the semiconductor chip 3 is shortened, making it possible to enhance sensor performance.

(Second Embodiment)

A modification of the sensor chip 10 will be described as a second embodiment of the present invention.

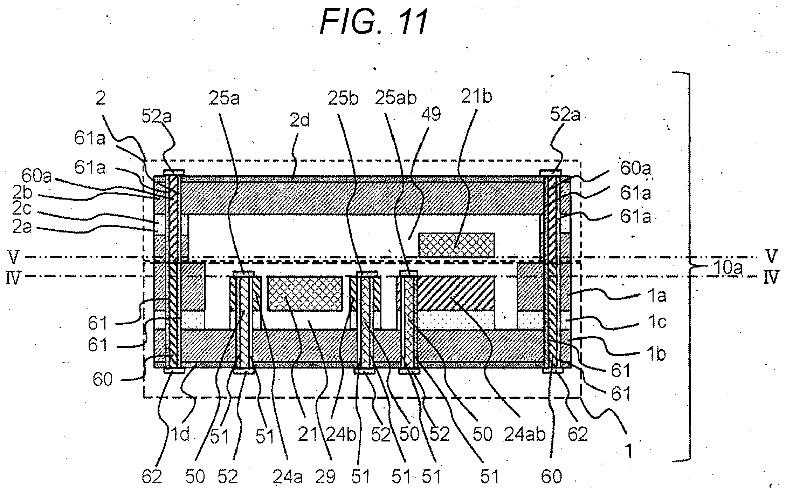

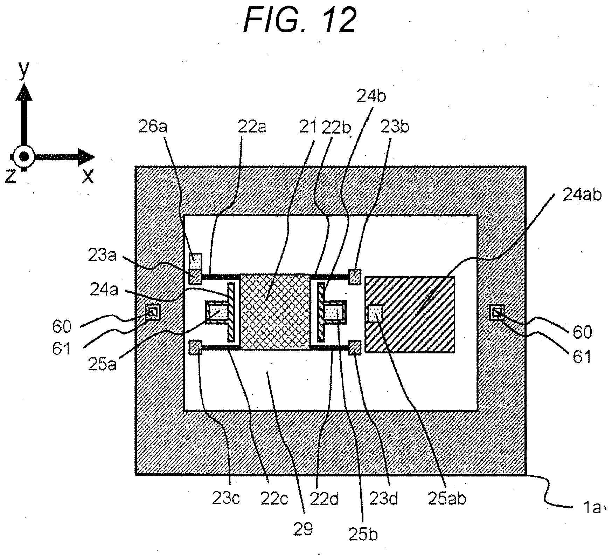

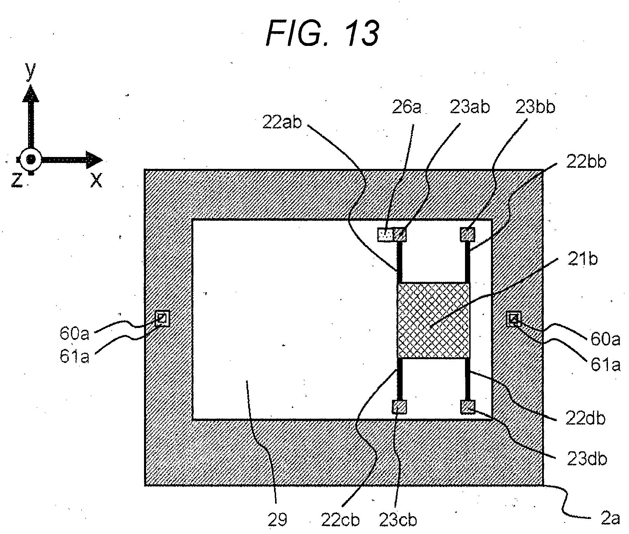

In the present embodiment, a sensor chip 10a is constituted with the acceleration detector 20 configured to detect acceleration in the y-axis direction and an acceleration detector 20c to be described below configured to detect acceleration in a direction (z-axis) orthogonal to the paper surface in FIG. 13. Hereinafter, in explanation of FIGS. 11, 12, 13, and 14, detailed descriptions of the same components as those in FIGS. 1 to 10 will be omitted, and different points will be mainly described.

FIG. 11 illustrates a modification of FIG. 2, and FIGS. 12 and 13 illustrate modifications of FIGS. 3 and 4. In the sensor chip 10a, the acceleration detector 20 is formed with the first laminate 1 similarly to the first embodiment. In contrast, the acceleration detector 20c is formed with the second laminate 2, while an electrode 24ab forming capacitance with a weight 21b is formed at a position facing the weight 21b, in the first laminate 1.

The acceleration detector 20c includes fixed portions 23ab, 23bb, 23cb, and 23db, and beams 22ab, 22bb, 22cb, and 22db, which are joined to the fixing portions respectively and support a weight 21b described below so as to be movable in the movable (Z) direction. Moreover, the acceleration detector 20c includes the weight 21b movable in the z-direction by application of acceleration, and also includes an electrode 24ab on the first substrate 1a of the first laminate as illustrated in FIG. 13 to form capacitance by facing the weight 21b in order to detect the displacement amount of the weight 21b as a change in capacitance. The acceleration detector 20c includes an electrode 25ab for exchanging signals with an external circuit, and similarly to the above description, the penetrating electrode 50 is connected to the electrode 25ab, while the electrode 52 is connected to the penetrating electrode 50 on the opposite side.

As described above, the sensor chip 10a can detect acceleration in the y-axis direction and acceleration in the z-axis direction.

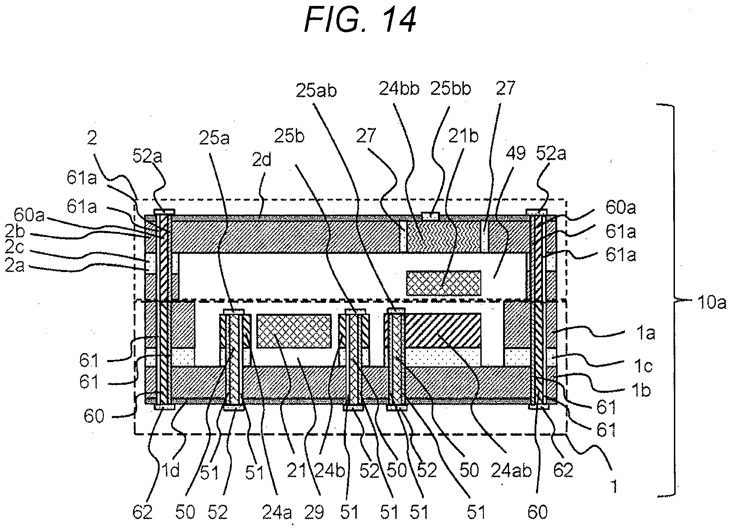

Alternatively, in the present embodiment, as illustrated in FIG. 6, in order to perform differential input of.the capacitance formed by facing the weight 21b into the CV converter 102, an electrode 24bb may be formed on the second substrate 2b of the second laminate 2 on the side opposite to the weight 21b and the electrode 24ab, as illustrated in FIG. 14, so as to generate a capacitance change in a direction opposite to the weight 21b and the electrode 24ab. At this time, in order to insulate the electrode 24bb from the other portion of the second substrate 2b, an insulating portion 27 is provided around a side wall of the electrode 24bb. In order to exchange signals with an external circuit, an electrode 25bb is provided on the opposite surface that does not face the weight 21b,of the electrode 24bb of the second substrate 2b. This configuration enables differential input to the CV converter 102, making it possible to increase the acceleration detection sensitivity.

Alternatively, in the present embodiment, the acceleration detector 20 may be formed in the second laminate 2, and the electrode 24ab and the electrode 25ab may be formed in the second laminate 2 in the acceleration detector 20c, with the others formed in the first laminate 1.

Furthermore, as a modification of the present embodiment, the angular velocity detector 30 may be formed instead of the acceleration detector 20. This enables formation of a sensor chip that detects the acceleration in the z-axis direction and the angular velocity about the z-axis.

Moreover, as a modification of the present embodiment, it is also allowable to provide a plurality of acceleration detectors 20c. In this case, the electrode 24ab and the electrode 25ab may be formed in the second laminate 2, with other electrodes being formed in the first laminate in one acceleration detector 20c, while the electrode 24ab and the electrode 25ab may be formed in the first laminate 1 with other electrodes being formed in the second laminate 2 in the other acceleration detector 20c. Then, by changing the dimensions of the beam and the weight, the thicknesses of the first substrates 1a and 2a to different values, and changing the spring constant $k_1$ and the mass $m_1$ illustrated in the Formula (7) to different values, it is possible to change acceleration detection ranges of individual acceleration detectors, enabling a sensor chip to increase the detection range without deteriorating the acceleration detection accuracy in the z-axis direction.

(Third Embodiment)

A modification of the sensor chip 10 will be described as a third embodiment of the present invention.

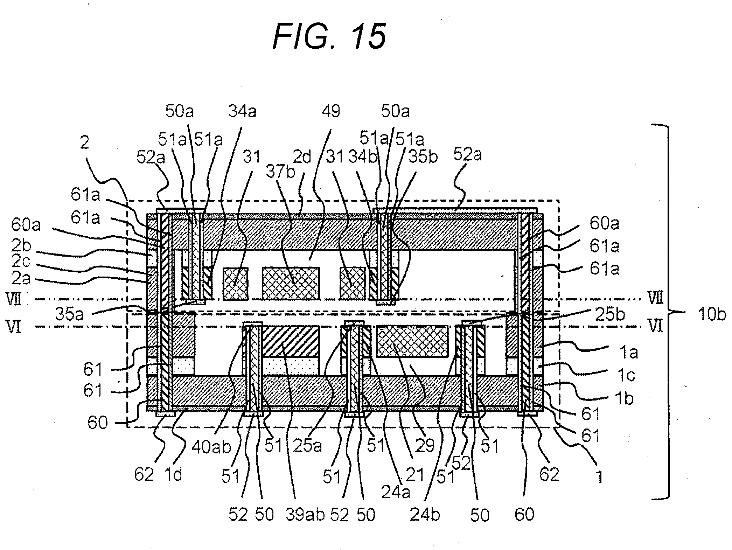

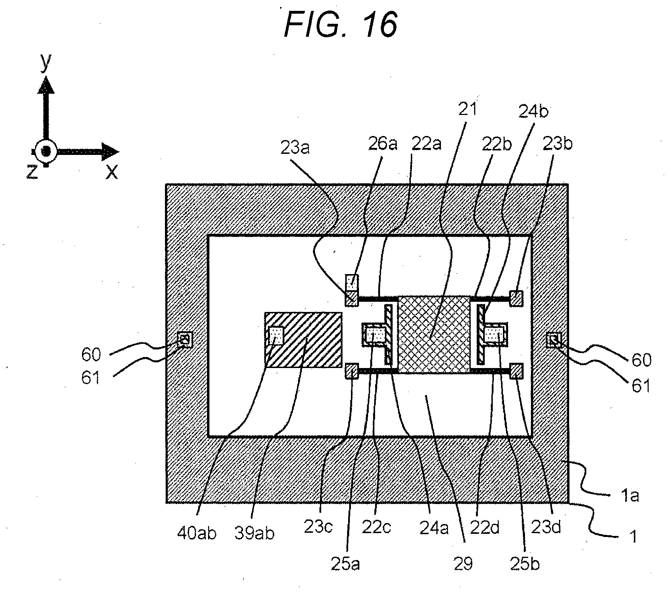

In the present embodiment, a sensor chip 10b is constituted with the acceleration detector 20 configured to detect acceleration in the y-axis direction and an acceleration detector 30b configured to detect angular velocity generated about the y-axis. Hereinafter, in explanation of FIGS. 15, 16, 17, and 18, detailed descriptions of the same components as those in FIGS. 1 to 14 will be omitted, and different points will be mainly described.

FIG. 15 illustrates a modification of FIG. 2, and FIGS. 16 and 17 illustrate modifications of FIGS. 3 and 4. As illustrated in FIG. 15, in the present sensor chip 10b, the acceleration detector 20 is formed of the first laminate 1 similarly to the first embodiment. In contrast, the angular velocity detector 30b is formed with the second laminate 2, while an electrode 39ab forming capacitance with a weight 37b is formed at a position facing the weight 37b, in the first laminate 1.

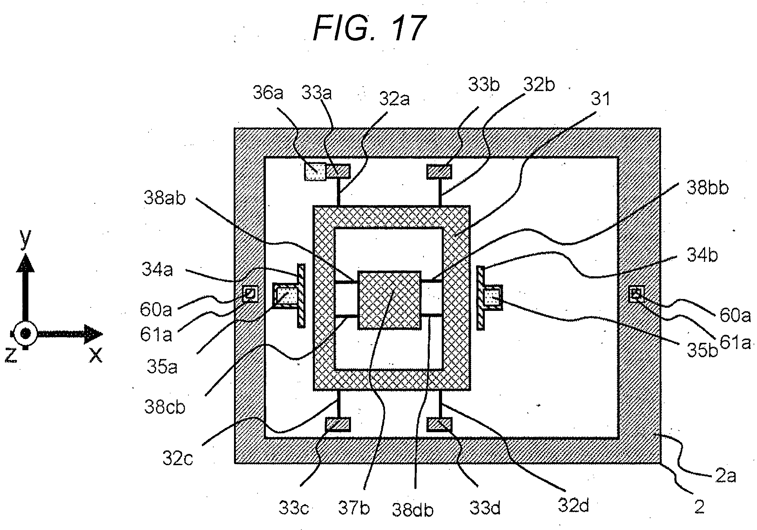

As illustrated in FIG. 17, the angular velocity detector 30b includes second beams 38ab, 38bb, 38cb, and 38db that join the second weight 37b to the first weight 31, while supporting the second weight 37b with the first weight 31 in a movable state in the direction (z-axis) orthogonal to the paper surface. Moreover, the angular velocity detector 30b includes the second weight 37b movable in the z-direction and also includes an electrode 39ab on the first substrate 1a of the first laminate 1 to form capacitance by facing the second weight 37b in order to detect the displacement amount of the second weight 37b in the z-direction at application of the angular velocity, as a change in capacitance. The angular velocity detector 30b includes an electrode 40ab for exchanging signals between the electrode 39ab and an external circuit, and similarly to the above description, the penetrating electrode 50 is connected to the electrode 40ab.

Next, operation of the angular velocity detector 30b will be described focusing on a difference from the above-described operation of the angular velocity detector 30. In a case where the angular velocity $\Omega$ is applied about the y-axis in a state where the first weight 31 and the second weight 37b vibrate in the x-axis direction, and when the mass of the second weight 37b is $m_{22}$, the Coriolis force Fc is generated in the z-axis direction as expressed by the above-described Formula (6). Then, the second weight 37b is displaced by the Coriolis force Fc in the z-axis direction.

The second weight 37b vibrates in the z-axis direction by the Coriolis force Fc expressed by Formula (6), leading to a change in the capacitance between the second weight 37b and the second electrode 39ab. By detecting this capacitance change, it is possible to detect the angular velocity $\Omega$ about the y-axis.

As described above, the sensor chip 10b can detect acceleration in the y-axis direction and the angular velocity about the y-axis.

As a modification of the present embodiment, for example, the angular velocity about the x-axis is detected by arranging the angular velocity detector 30 to be rotated by 90 degrees about the z-axis.

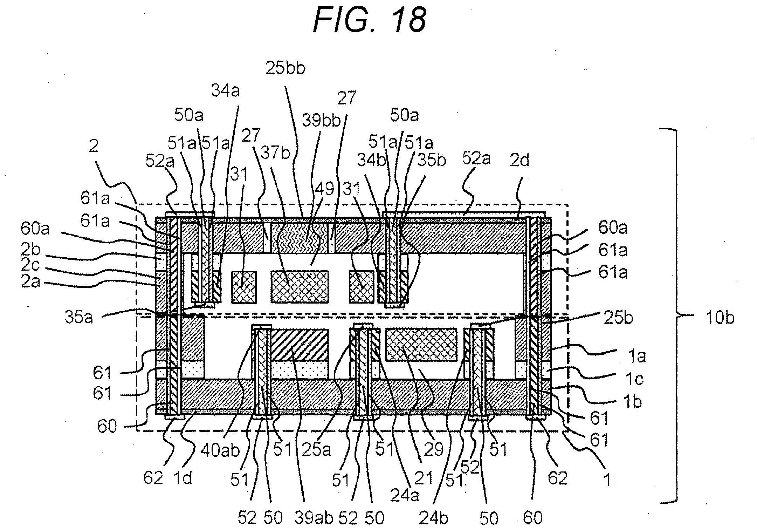

Alternatively, in the present embodiment, as illustrated in FIG. 18, it is allowable to configure to generate a capacitance change in a direction opposite to the weight 37b and the electrode 39ab in order to perform differential input of the capacitance formed by facing the weight 37b into the CV converter 202. In this case, for example, as illustrated in FIG. 18, an electrode 39bb may be formed on the second substrate 2b opposite to the weight 37b and the electrode 39ab. At this time, in order to insulate the electrode 39bb from the other portion of the second substrate 2b, the insulating portion 27 is provided around a side wall of the electrode 39bb. In order to exchange signals with an external circuit, the electrode 25bb is provided on the opposite surface that does not face the weight 21b of the electrode 39bb. As described above, differential input can be performed to the CV converter 202, making it possible to increase the angular velocity detection sensitivity.

Alternatively, as a modification of the present embodiment, the acceleration detector 20 may be formed in the second laminate 2, and the electrode 39ab and the electrode 40ab may be formed in the second laminate 2 in the angular velocity detector 30b, with the others formed in the first laminate 1.

Moreover, as a modification of the present embodiment, the angular velocity detector 30 may be formed instead of the acceleration detector 20. This enables formation of a sensor chip that detects the angular velocity about two axes, that is, about the z-axis and the y-axis.

Moreover, as a modification of the present embodiment, it is also allowable to provide a plurality of angular velocity detectors 30b. In this case, the electrode 39ab and the electrode 40ab may be formed in the second laminate 2, with other electrodes being formed in the first laminate 1 in one angular velocity detector 30b, while the electrode 39ab and the electrode 39ab may be formed in the first laminate 1 with other electrodes being -formed in the second laminate 2 in the other angular velocity detector 30b.

At this time, by changing the dimensions of the beam and the weight, and the thickness of the first substrate 1a, so as to change the frequency f and the mass $m_2$ of the weight expressed in Formulas (8) and (9) to different values, it is possible to change the detection range of the angular velocity, enabling the sensor chip 10b to be a uniaxial angular velocity sensor with a wider detection range without deteriorating detection accuracy.

. Alternatively, by arranging one of the angular velocity detectors 30b to be rotated by 90 degrees about the z-axis with respect to the other angular velocity detector 30b, it is possible to form a sensor chip that detects the angular velocity of each of two axes, that is, the y-axis and the x-axis.

(Fourth Embodiment)

A modification of the sensor chip 10 will be described as a fourth embodiment of the present invention. In the present embodiment, a sensor chip 10c is constituted with the acceleration detector 20 configured to detect acceleration, the angular velocity detector 30, and a pressure detector 300 that detects pressure.

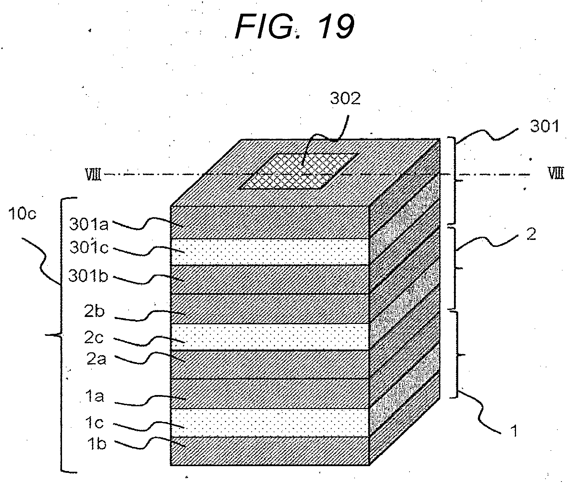

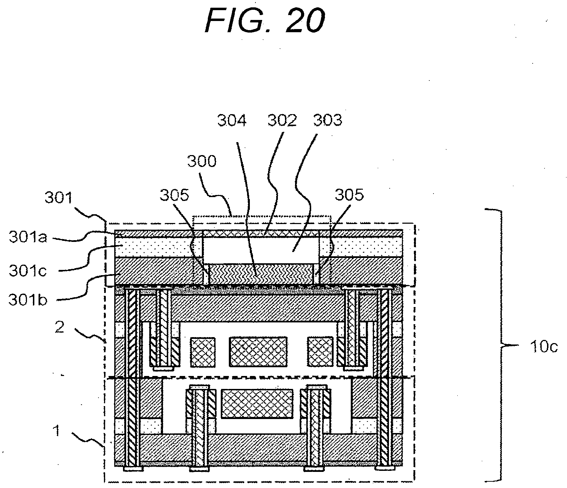

Hereinafter, in explanation of FIGS. 19 and 20, detailed descriptions of the same components as those in FIGS. 1 to 18 will be omitted, and different points will be mainly described.

FIG. 19 illustrates a modification of FIG. 1, and FIG. 20 illustrates a modification of FIG. 2. In the sensor chip 10c, the acceleration detector 20 is formed of the first laminate 1 similarly to the first embodiment. In contrast, the angular velocity detector 30 is formed with the second laminate 2. The pressure detector 300 is formed with a third laminate 301.

The pressure detector 300 includes on the substrate 301a a deformable portion 302 that deforms in a direction perpendicular to a plane by applying pressure and includes a cavity 303 formed immediately below the deformable portion 302 in an oxide film 301c, or in the oxide film 301c and a portion of a substrate 301b.

Note that in a case where deformation of the deformable portion 302 is detected by the capacitance of the cavity, an electrode 304 is formed on the substrate 301b side opposed to the deformable portion 302 via the cavity 303. At this time, in order to insulate the electrode 304 from the other portion of the second substrate 301b, an insulating portion 305 is provided around a side wall of the electrode 304.

On the other hand, the deformation of the deformable portion 302 may be configured to detect a change in piezoresistance of the deformable portion 302.

Moreover, by eliminating the resin 75 immediately above the deformable portion 302 in a chip package of the sensor chip 10c, it is possible to enhance pressure detection accuracy.

In the above sensor chip 10c, for example, in a case where the pressure detector 300 detects the vicinity of the atmospheric pressure (0.1 MPa) and includes a temperature measuring function on the semiconductor chip 3, or the like, an atmospheric pressure P at this time can be converted into an altitude H as expressed in Formula (9). This enables highly accurate detection of the position of the sensor chip 10c.

[Mathematical Formula 9]

$$H = \frac{\left(\frac{P_0}{P}\right)^{\frac{1}{5.257}} - 1}{0.0065} \times (T + 273.15) \quad \cdots (9)$$

In Formula (9), $P_0$ and T are the following numerical values.

$P_0$: sea level atmospheric pressure
T: temperature

In another case, for example, where the pressure detector 300 in the sensor chip 10c detects the pressure (about 0.1 MPa to 1 MPa) of a gas filled in a tire, by installing the sensor chip in the tire or inside a tire wheel, the rotation of the tire or the tire wheel can be detected by the acceleration detector 20 and the angular velocity detector 30, and at the same time, the pressure inside the tire can be detected by the pressure detector 300. With this configuration, it is possible to perform monitoring of the state of the tire with high accuracy and to enhance running safety of a vehicle.

While the embodiment of the present invention has been described above, the inertial force sensor of the present invention is not limited to these, and various modifications are possible. For example, each of the number of the first laminate. 1, the second laminate 2, and the third laminate may be two. Moreover, in each of the laminates, there may be two or more detectors, or two or more types of detectors. Moreover, the chip packages 4 and 4a may employ a resin substrate or ceramics instead of the lead frame 72 and may be formed as a ball grud array (BGA) package in which electrodes are extracted onto the back surface of the substrate by solder balls. Reference Signs List

| | |
|---|---|
| 1 | first laminate |
| 1a | first substrate (first laminate) |
| 1b | second substrate (first laminate) |
| 1c | oxide film (first laminate) |
| 1d | insulating film (first laminate) |
| 2 | second laminate |
| 2a | first substrate (second laminate) |
| 2b | second substrate (second laminate) |
| 2c | oxide film (second laminate) |
| 2d | insulating film (second laminate) |
| 3 | semiconductor chip |
| 3a | semiconductor chip |
| 3b | semiconductor chip |
| 4 | chip package |
| 4a | chip package (modification) |

| | |
|---|---|
| 10 | sensor chip |
| 10a | sensor chip |
| 10b | sensor chip |
| 10c | sensor chip |
| 20 | acceleration detector (y-axis direction) |
| 20a | acceleration detector (x-axis direction) |
| 20b | acceleration detector |
| 20c | acceleration detector (z-axis direction) |
| 21 | weight |
| 21b | weight |
| 22a | beam |
| 22b | beam |
| 22c | beam |
| 22d | beam |
| 22ab | beam |
| 22bb | beam |
| 22cb | beam |
| 22db | beam |
| 23a | fixed portion |
| 23b | fixed portion |
| 23c | fixed portion |
| 23d | fixed portion |
| 23ab | fixed portion |
| 23bb | fixed portion |
| 23cb | fixed portion |
| 23db | fixed portion |
| 24a | electrode |
| 24b | electrode (for differential) |
| 24ab | electrode |
| 24bb | electrode (for differential) |
| 25a | electrode (for external circuit connection) |
| 25b | electrode (for external circuit connection) |
| 25ab | electrode (for external circuit connection) |
| 25bb | electrode (for external circuit connection) |
| 26a | electrode (for external circuit connection) |
| 29 | cavity |
| 30 | angular velocity detector (about z-axis) |
| 30a | angular velocity detector (about z-axis) |
| 30b | angular velocity detector (about y-axis) |
| 30q1 | angular velocity detector (left side) |
| 30q2 | angular velocity detector (right side) |
| 31 | first weight |
| 31q1 | first weight (left side) |
| 31q2 | first weight (right side) |
| 32a | first beam |
| 32b | first beam |
| 32c | first beam |
| 32d | first beam |
| 33a | fixed portion |
| 33b | fixed portion |
| 33c | fixed portion |
| 33d | fixed portion |
| 34a | first electrode |
| 34b | first electrode |
| 35a | electrode (for external circuit connection) |
| 35b | electrode (for external circuit connection) |
| 36a | electrode (for external circuit connection) |
| 37 | second weight |

| | |
|---|---|
| 37b | second weight |
| 37q1 | second weight (left side) |
| 37q2 | second weight (right side) |
| 38a | second beam |
| 38b | second beam |
| 38c | second beam |
| 38d | second beam |
| 38ab | second beam |
| 38bb | second beam |
| 38cb | second beam |
| 38db | second beam |
| 39a | second electrode |
| 39b | second electrode (for differential) |
| 39ab | second electrode |
| 39bb | second electrode (for differential) |
| 40a | electrode (for external circuit connection) |
| 40b | electrode (for external circuit connection) |
| 40ab | electrode (for external circuit connection) |
| 41 | third beam |
| 49 | cavity |
| 50 | penetrating electrode |
| 50a | penetrating electrode |
| 51 | insulating film (penetrating electrode outer periphery) |
| 51a | insulating film (penetrating electrode outer periphery) |
| 52 | electrode |
| 52a | electrode |
| 60 | penetrating electrode |
| 60a | penetrating electrode |
| 61 | insulating film (penetrating electrode outer periphery) |
| 61a | insulating film (penetrating electrode outer periphery) |
| 62 | electrode |
| 70 | adhesive |
| 70a | adhesive |
| 71 | first wire bonding |
| 72 | lead frame |
| 73 | adhesive |
| 74 | second wire bonding |
| 75 | resin |
| 76 | conductive material |
| 81 | electrode |
| 82 | electrode |
| 100 | integrated circuit (for acceleration) |
| 101 | carrier wave (for acceleration) |
| 102 | CV converter (for acceleration) |
| 103 | synchronous detector (for acceleration) |
| 104 | acceleration signal (for acceleration) |
| 200 | integrated circuit (for angular velocity) |
| 201 | carrier wave (for angular velocity) |
| 202 | CV converter (for angular velocity) |
| 203 | synchronous detector (for angular velocity) |
| 204 | angular velocity signal |
| 205 | oscillator |
| 206 | amplifier |
| 300 | pressure detector |
| 301 | third laminate |
| 301a | first substrate (third laminate) |
| 301b | second substrate (third laminate) |
| 301c | oxide film (third laminate) |

302    deformable portion
303    cavity
304    electrode
305    insulating portion

**Claims**

1.  An inertial force sensor comprising a layer in which a detector is formed,
    wherein the layer is a laminated structure in which two or more layers are laminated.

2.  The inertial force sensor according to claim 1,
    wherein the detector includes a movable body and an electrode.

3.  The inertial force sensor according to claim 2,
    wherein at least one pair of detectors is arranged such that the movable body and the electrode are formed in a same layer.

4.  The inertial force sensor according to claim 2,
    wherein at least one pair of detectors is arranged such that the movable body and the electrode are formed in mutually different layers.

5.  The inertial force sensor according to claim 4,
    wherein, in the detector in which the movable body and the electrode are formed in mutually different layers, the electrode is formed in the same layer as the layer in which the movable body of another detector is formed.

6.  The inertial force sensor according to any one of claims 1 to 5,
    wherein the at least one pair of detectors are provided in two sets or more, and arranged in an array.

7.  The inertial force sensor according to any one of claims 1 to 6,
    wherein a signal of the sensor is extracted solely on one side of the laminated structure.

8.  The inertial force sensor according to claim 7,
    wherein a signal of the detector passes through the laminated structure.

9.  The inertial force sensor according to any one of claims 1 to 8,
    wherein at least one layer has a structure of a microelectromechanical system.

10. The inertial force sensor according to any one of claims 1 to 9,
    wherein at least one detector has a portion that detects pressure.

11. The inertial force sensor according to any one of claims 1 to 10,
    wherein at least one layer is a layer in which an LSI element is formed.

12. The inertial force sensor according to any one of claims 1 to 10,
    wherein at least one layer is a layer in which a semiconductor memory is formed.

13. The inertial force sensor according to any one of claims 1 to 10,
    wherein at least one layer is a layer in which a circuit that converts a digital signal into an analog signal is formed.

14. The inertial force sensor according to any one of claims 1 to 10,
    wherein at least one layer is a layer in which a circuit that converts an analog signal into a digital signal is formed.

15. The inertial force sensor according to any one of claims 1 to 10,
    wherein at least one layer is a layer in which an LSI element is formed, and
    at least one layer is a layer in which a semiconductor memory is formed.

16. The inertial force sensor according to any one of claims 1 to 15,

wherein at least one pair of detectors is airtight against the outside of the laminated structure.

17. The inertial force sensor according to any one of claims 1 to 16,
    wherein at least one pair of detectors detects one of acceleration and angular velocity, and
    at least one pair of detectors detects one of acceleration and angular velocity.

FIG. 1

# FIG. 2

EP 3 358 357 A1

# FIG. 3

# FIG. 4

# FIG. 5

# FIG. 6

# FIG. 7

## FIG. 8

EP 3 358 357 A1

# FIG. 9

# FIG. 10

FIG. 11

FIG. 12

EP 3 358 357 A1

## FIG. 13

## FIG. 14

EP 3 358 357 A1

EP 3 358 357 A1

# FIG. 15

# FIG. 16

EP 3 358 357 A1

*FIG. 17*

FIG. 18

EP 3 358 357 A1

# FIG. 19

# FIG. 20

**INTERNATIONAL SEARCH REPORT**

| International application No. |
| --- |
| PCT/JP2016/072713 |

| A.  CLASSIFICATION OF SUBJECT MATTER |
| --- |
| *G01P15/08*(2006.01)i, *B81B3/00*(2006.01)i, *G01C19/5747*(2012.01)i, *G01C19/5783*(2012.01)i, *G01D21/02*(2006.01)i, *G01L9/00*(2006.01)i, *G01P15/125*(2006.01)i, *G01P15/18*(2013.01)i, *H01L29/84*(2006.01)i |
| According to International Patent Classification (IPC) or to both national classification and IPC |

| B.  FIELDS SEARCHED |
| --- |
| Minimum documentation searched (classification system followed by classification symbols)<br>G01P15/08, B81B3/00, G01C19/5747, G01C19/5783, G01D21/02, G01L9/00, G01P15/125, G01P15/18, H01L29/84 |

| Documentation searched other than minimum documentation to the extent that such documents are included in the fields searched |
| --- |
| Jitsuyo Shinan Koho        1922–1996   Jitsuyo Shinan Toroku Koho   1996–2016<br>Kokai Jitsuyo Shinan Koho    1971–2016   Toroku Jitsuyo Shinan Koho   1994–2016 |

| Electronic data base consulted during the international search (name of data base and, where practicable, search terms used) |
| --- |
|  |

| C.  DOCUMENTS CONSIDERED TO BE RELEVANT |
| --- |

| Category* | Citation of document, with indication, where appropriate, of the relevant passages | Relevant to claim No. |
| --- | --- | --- |
| X | WO 2014/208116 A1  (Hitachi Automotive Systems, Ltd.),<br>31 December 2014 (31.12.2014),<br>fig. 15, 16<br>& JP 5978170 B2<br>fig. 15, 16<br>& DE 112014003020 T5<br>fig. 15, 16<br>& US 2016/0131678 A1<br>fig. 15, 16 | 1–17 |

| ☐ Further documents are listed in the continuation of Box C. | | ☐ See patent family annex. | |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    15 September 2016 (15.09.16) | Date of mailing of the international search report<br>    27 September 2016 (27.09.16) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5298047 B